# EUROPEAN PATENT SPECIFICATION

(11) **EP 3 605 542 B1**
(45) Date of publication and mention of the grant of the patent: **21.07.2021**
(21) Application number: 17905894.6
(22) Date of filing: 14.04.2017
(51) Int. Cl.: G11C 11/406, G06F 13/16

(54) **MEMORY REFRESHING TECHNIQUE AND COMPUTER SYSTEM**
SPEICHERAUFFRISCHTECHNIK UND COMPUTERSYSTEM
TECHNIQUE DE RAFRAÎCHISSEMENT DE MÉMOIRE ET SYSTÈME INFORMATIQUE

(43) Date of publication of application: 05.02.2020
(73) Proprietor: Huawei Technologies Co., Ltd., Longgang District Shenzhen, Guangdong 518129 (CN)
(72) Inventor: HU, Xing, Shenzhen Guangdong 518129 (CN); LIANG, Chuanzeng, Shenzhen Guangdong 518129 (CN); XIAO, Shihai, Shenzhen Guangdong 518129 (CN); WANG, Kanwen, Shenzhen Guangdong 518129 (CN)
(74) Representative: Kreuz, Georg Maria
(86) International application number: PCT/CN2017/080640
(87) International publication number: WO 2018/188085

(56) References cited:
- CN-A- 101 000 798
- CN-A- 104 143 355
- CN-A- 105 280 215
- GB-A- 2 499 053
- US-A1- 2010 162 020
- US-A1- 2012 144 106
- US-B1- 9 576 637

## Description

### TECHNICAL FIELD

This application relates to the field of computer technologies, and in particular, to a memory refresh technology and a computer system.

### BACKGROUND

A conventional main memory of a system usually includes a dynamic random access memory (DRAM). A DRAM has a simple structure and a high read speed. The most fundamental storage unit of a DRAM is a DRAM cell, and each DRAM cell includes a transistor and a capacitor. The DRAM cell indicates 0 or 1 by using a quantity of charges in the capacitor. In this manner, one DRAM cell can store one bit. The charges in the capacitor may leak away, and insufficient charges in the capacitor may result in an error in stored data. Therefore, during actual application, the capacitor needs to be periodically charged to retain information stored in the capacitor. This action of charging the capacitor in the DRAM is referred to as a refresh.

DRAM cells in the DRAM are arranged into a matrix. This matrix is referred to as a DRAM bank. Any bit in the DRAM bank can be positioned by using a corresponding row and column decoder. A plurality of DRAM banks may form a DRAM chip, a plurality of DRAM chips may form a DRAM rank, and a plurality of DRAM ranks may be integrated into a dual in-line memory module (DIMM). DRAM cells are refreshed by a sense amplifier (Sense Amp) on a per-row basis. In a refresh process, rows in one or more banks may be refreshed according to a refresh command. During actual application, a refresh is usually performed by using a rank as a unit. Specifically, rows of all banks in the rank need to be refreshed at least once within a retention time. The retention time is a time within which data in a DRAM cell can be retained without a refresh operation.

A person skilled in the art may know that, a memory controller checks, at intervals of a tREFI time, whether a rank needs to be refreshed. Each refresh needs to consume a tRFC time. tREFI is used to indicate an average refresh interval, and tRFC is used to indicate a row refresh cycle time. In other words, tREFI is used to indicate an average interval at which the memory controller sends a refresh command, and tRFC is used to indicate a time required for executing one refresh command in a DRAM rank. In a prior-art refresh solution, when the rank is idle, the memory controller refreshes the rank; or when the rank is not idle, the memory controller postpones refreshing the rank. When a postponement time exceeds a threshold, the memory controller forcibly refreshes the rank, and performs a make-up refresh for the postponed refresh. Therefore, a relatively large quantity of refreshes are caused within a time period requiring a make-up refresh. In a refresh process, within such a time window of tRFC, a rank being refreshed cannot respond to another operation request. Therefore, such a forcible make-up refresh may result in relatively high refresh overheads of a system.

GB 2499053 relates to an apparatus and method for controlling secure refreshing of data in a DRAM.

US 9,576,637 relates to data processing systems, and more particularly to refreshing memory systems in data processing systems.

US 2012/0144106 relates to memory devices, and more particularly to changing memory device refresh rate on the fly.

### SUMMARY

This application provides a memory refresh technology and a computer system, so as to reduce a refresh loss of a system, and improve computer system performance in a refresh process. The invention is set out in the appended set of claims.

According to a first aspect, an embodiment of the present invention provides a memory refresh method. The method is applied to a computer system including a memory controller and a dynamic random access memory DRAM. In the method, the memory controller receives access requests. When a quantity of access requests for accessing a first rank in the DRAM that are in the received access requests is greater than 0 and less than a second threshold, the memory controller refreshes the first rank.

In the memory refresh method in this embodiment of the present invention, to mitigate impact caused on computer system performance by a memory refresh process, both a status of the received access requests and a status of a to-be-accessed target rank are comprehensively considered for determining whether the target rank needs to be refreshed. Specifically, when the quantity of the access requests for accessing the first rank in the DRAM that are in the received access requests is greater than 0 and less than the second threshold, the memory controller may refresh the first rank. In this manner, the first rank can be actively refreshed even if the first rank is not in an idle state. Therefore, when access traffic is relatively heavy, the first rank can be refreshed in time even if the first rank cannot be in an idle state. Impact caused on computer system performance by a passive refresh caused by a refresh postponement is mitigated, and memory refresh flexibility is improved. Therefore, system performance can be improved, and refresh overheads can be reduced.

In a first possible implementation, the refreshing, by the memory controller, the first rank includes: refreshing, by the memory controller, the first rank at a T/N interval when a quantity of target ranks of the received access requests is less than a specified fourth threshold and a proportion of read requests or write requests in the access requests is greater than a specified fifth threshold, where T is used to indicate a standard average refresh interval, and N is an integer greater than 1.

In this embodiment of the present invention, in a memory refresh process, a refresh mode may be further selected based on a distribution of the to-be-accessed target ranks of the access requests and a read or write proportion in the access requests. Specifically, when the to-be-accessed target ranks are relatively concentrated and the proportion of read requests or write requests in the access requests is relatively large, an interval between single refreshes may be reduced, that is, the first rank is refreshed at a higher refresh frequency. Because an average refresh interval is relatively short and a time required for a single refresh is also relatively short, in a single refresh process, the system is less affected by a tFAW limitation, and overall system performance is less lowered. In this manner, impact caused on the system in a refresh process by the tFAW limitation in the DDR protocol can be mitigated, and system performance can be improved.

With reference to the first aspect and the first possible implementation of the first aspect, in a second possible implementation, in a process in which the memory controller refreshes the first rank, the memory controller receives a first access request for accessing the first rank, and then the memory controller buffers the first access request in a configured buffer queue. The memory controller includes at least the buffer queue and a scheduling queue, the buffer queue is used to buffer an access request for a rank on which a refresh operation is being performed, and the scheduling queue is used to buffer an access request to be sent to a rank on which a refresh operation is not being performed. In this manner, the access request, received in a process of refreshing the first rank, for the first rank can be prevented from congesting the scheduling queue and from affecting processing, by the memory controller, on an access request for another rank. Processing efficiency of the entire computer system is further improved.

With reference to the second possible implementation of the first aspect, in a third possible implementation, the memory controller further receives a second access request for accessing a second rank in the DRAM. The memory controller buffers the second access request in the scheduling queue when the second rank is not being refreshed.

With reference to any one of the first aspect or the first to the third possible implementations of the first aspect, in a fourth possible implementation, the method further includes: refreshing, by the memory controller, the second rank when a quantity of access requests for accessing the second rank in the DRAM that are in the received access requests is not less than the second threshold and a quantity of postponed refreshes on the second rank is greater than a specified third threshold. The third threshold is not less than 1 and is less than a specified warning value, and the warning value is used to indicate a need to immediately perform a refresh operation on the second rank.

With reference to any one of the first aspect or the first to the fourth possible implementations of the first aspect, in a fifth possible implementation, the method further includes: skipping, by the memory controller, performing a refresh operation on a third rank when a quantity of access requests for accessing the third rank in the DRAM that are in the received access requests is not less than the second threshold and a quantity of postponed refreshes on the third rank is not greater than the specified third threshold. The third threshold is not less than 1 and is less than a specified warning value, and the warning value is used to indicate a need to immediately perform a refresh operation on the third rank.

With reference to the first aspect, in a sixth possible implementation, the refreshing, by the memory controller, the first rank includes: refreshing, by the memory controller, the first rank at a T interval when a quantity of target ranks of the received access requests is not less than a specified fourth threshold and a proportion of read requests or write requests in the access requests is not greater than a specified fifth threshold. T is used to indicate a standard average refresh interval.

With reference to any one of the first aspect or the first to the sixth possible implementations of the first aspect, in a seventh possible implementation, the method further includes: refreshing, by the memory controller, the third rank when the memory controller determines that a quantity of access requests received within another time period is not greater than a first threshold and a quantity of access requests for accessing the third rank in the DRAM is greater than 0 if a quantity of postponed refreshes on the third rank is greater than the specified third threshold. The third threshold is less than the specified warning value, and the warning value is used to indicate a need to immediately refresh the third rank.

With reference to any one of the first aspect or the first to the seventh possible implementations of the first aspect, in an eighth possible implementation, the method further includes: skipping, by the memory controller, refreshing the second rank when the memory controller determines that a quantity of access requests received within another time period is not greater than the first threshold and a quantity of access requests for accessing the second rank in the DRAM is greater than 0 if a quantity of postponed refreshes on the second rank is not greater than the specified third threshold. The third threshold is less than the specified warning value, and the warning value is used to indicate a need to immediately refresh the second rank.

According to a second aspect, this application provides a computer system. The computer system includes a memory controller and a dynamic random access memory DRAM connected to the memory controller. The memory controller is configured to perform the method according to any one of the first aspect or the possible implementations of the first aspect.

According to a third aspect, this application provides a memory controller. The memory controller is configured to refresh a dynamic random access memory DRAM in a computer system. The memory controller includes a communications interface and a refresh circuit. The communications interface is configured to receive access requests sent by a processor in the computer system. The refresh circuit is configured to refresh a first rank when a quantity of access requests for accessing the first rank in the dynamic random access memory DRAM in the computer system that are in the received access requests is greater than 0 and less than a second threshold.

With reference to the third aspect, in a first possible implementation, the refresh circuit is specifically configured to refresh the first rank at a T/N interval when a quantity of target ranks of the received access requests is less than a specified fourth threshold and a proportion of read requests or write requests in the access requests is greater than a specified fifth threshold, where T is used to indicate a standard average refresh interval, and N is an integer greater than 1.

With reference to the third aspect and the first possible implementation of the third aspect, in a second possible implementation, the communications interface is further configured to: in a process in which the refresh circuit refreshes the first rank, receive a first access request for accessing the first rank. The memory controller further includes a buffer, where the buffer is configured to buffer the first access request in a configured buffer queue. The buffer includes at least the buffer queue and a scheduling queue, the buffer queue is used to buffer an access request for a rank on which a refresh operation is being performed, and the scheduling queue is used to buffer an access request to be sent to a rank on which a refresh operation is not being performed.

With reference to the second possible implementation of the third aspect, in a third possible implementation, the communications interface is further configured to receive a second access request for accessing a second rank in the DRAM. The buffer is further configured to buffer the second access request in the scheduling queue when the second rank is not being refreshed.

With reference to any one of the third aspect or the first to the third possible implementations of the third aspect, in a fourth possible implementation, the refresh circuit is further configured to refresh the second rank when a quantity of access requests for accessing the second rank in the DRAM that are in the received access requests is not less than the second threshold and a quantity of postponed refreshes on the second rank is greater than a specified third threshold. The third threshold is not less than 1 and is less than a specified warning value, and the warning value is used to indicate a need to immediately perform a refresh operation on the second rank.

With reference to any one of the third aspect or the first to the fourth possible implementations of the third aspect, in a fifth possible implementation, the refresh circuit is further configured to skip performing a refresh operation on a third rank when a quantity of access requests for accessing the third rank in the DRAM that are in the received access requests is not less than the second threshold and a quantity of postponed refreshes on the third rank is not greater than the specified third threshold, where the third threshold is not less than 1 and is less than the specified warning value, and the warning value is used to indicate a need to immediately perform a refresh operation on the third rank.

With reference to the third aspect, in a sixth possible implementation, the refresh circuit is specifically configured to refresh the first rank at a T interval when a quantity of target ranks of the received access requests is not less than a specified fourth threshold and a proportion of read requests or write requests in the access requests is not greater than a specified fifth threshold, where T is used to indicate a standard average refresh interval.

According to a fourth aspect, this application further provides a memory refresh apparatus. The memory refresh apparatus is configured to refresh a dynamic random access memory DRAM in a computer system. The memory refresh apparatus includes function modules configured to perform the method according to any one of the first aspect or the possible implementations of the first aspect.

According to a fifth aspect, this application further provides a computer program product, including program code, where instructions included in the program code are executed by a computer, to implement the method according to any one of the first aspect or the possible implementations of the first aspect.

According to a sixth aspect, this application further provides a computer readable storage medium, where the computer readable storage medium is configured to store program code, and instructions included in the program code are executed by a computer, to implement the method according to any one of the first aspect or the possible implementations of the first aspect.

### BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention.
FIG. 1 is a schematic architectural diagram of a computer system according to an embodiment of the present invention;
FIG. 2 is a schematic structural diagram of a memory controller according to an embodiment of the present invention;
FIG. 3 is a schematic flowchart of a memory refresh method according to an embodiment of the present invention; and
FIG. 4 is a schematic structural diagram of a memory refresh apparatus according to an embodiment of the present invention.

### DESCRIPTION OF EMBODIMENTS

To make a person skilled in the art better understand the technical solutions in the present invention, the following clearly describes the technical solutions in the embodiments of the present invention with reference to the accompanying drawings in the embodiments of the present invention. Apparently, the described embodiments are merely some but not all of the embodiments of the present invention.

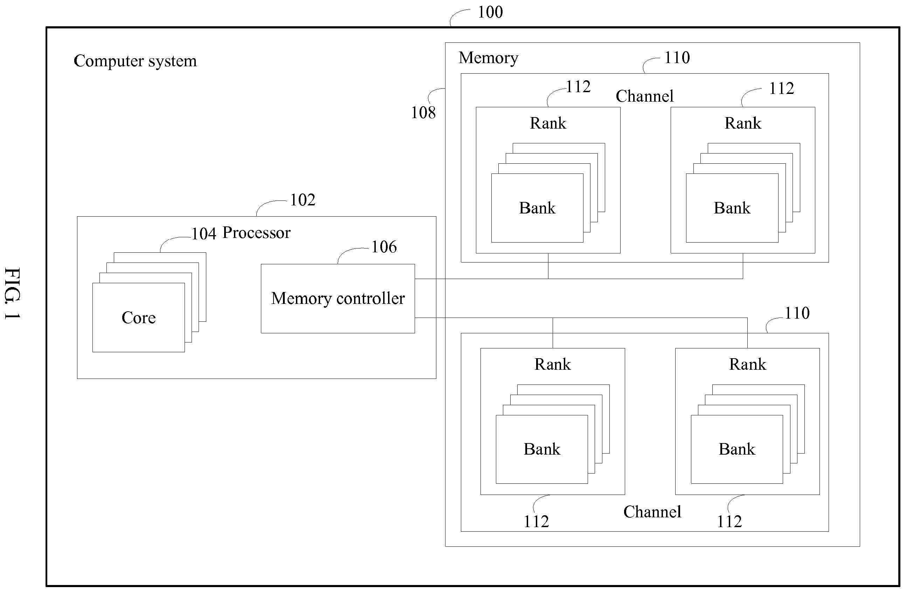

FIG. 1 is a schematic architectural diagram of a computer system according to an embodiment of the present invention. As shown in FIG. 1, a computer system 100 may include at least a processor 102, a memory controller 106, and a memory 108. Usually, the memory controller 106 may be integrated into the processor 102. It should be noted that, in the computer system provided in this embodiment of the present invention, in addition to components shown in FIG. 1, the computer system 100 may further include other components such as a communications interface and a magnetic disk serving as an external storage. No limitation is imposed herein.

The processor 102 is a computing unit and a control unit of the computer system 100. The processor 102 may include a plurality of processor cores 104. The processor 102 may be a very large-scale integrated circuit. An operating system and another software program are installed in the processor 102, so that the processor 102 can access the memory 108, a buffer, and a magnetic disk. It may be understood that, in this embodiment of the present invention, the core 104 of the processor 102 may be, for example, a central processing unit (CPU), or may be another application-specific integrated circuit (ASIC).

The memory controller 106 is a bus circuit controller that is inside the computer system 100 and that controls the memory 108 and is configured to manage and plan data transmission from the memory 108 to the core 104. The memory 108 may exchange data with the core 104 through the memory controller 106. The memory controller 106 may be a separate chip, and connected to the core 104 through a system bus. A person skilled in the art may know that, the memory controller 106 may be integrated into the processor 102 (as shown in FIG. 1), or may be built in a north bridge. A specific location of the memory controller 20 is not limited in this embodiment of the present invention. During actual application, the memory controller 106 may control necessary logic to write data to the memory 108 or read data from the memory 108.

The memory 108 is a main memory of the computer system 100. The memory 108 is connected to the processor 102 through a double data rate (DDR) bus. The memory 108 is usually configured to store various software currently running on the operating system, input and output data, and information that is exchanged with the external storage. To increase an access speed of the processor 102, the memory 108 needs to have an advantage of a high access speed. In a conventional computer system architecture, a dynamic random access memory (DRAM) is usually used as the memory 108. Through the memory controller 106, the processor 102 can access the memory 108 at a high speed, and perform a read operation and a write operation on any storage unit in the memory 108.

In this embodiment of the present invention, that the memory 108 is a DRAM is used as an example for description. Therefore, the memory 108 may also be referred to as a DRAM 108. Data is stored in a storage unit (which may also be referred to as a DRAM cell) of the DRAM 108. In this embodiment of the present invention, the storage unit is a minimum storage unit (cell) for storing data. Generally, one storage unit may store 1 bit (bit) data. Certainly, some storage units may alternatively store a plurality of values. As described above, the DRAM indicates data 0 or 1 by using a quantity of charges in a capacitor. The charges in the capacitor may leak away, and insufficient charges in the capacitor may result in an error in stored data. Therefore, the memory controller 106 refreshes data in the DRAM 108 at intervals of a time period, to avoid a data loss in the DRAM 108. Moreover, the DRAM 108 is volatile, and when the computer system 100 is powered off, information in the DRAM 108 is no longer saved.

During actual application, DRAM cells in the DRAM 108 are arranged into a matrix. This matrix is referred to as a DRAM bank. Any bit in the DRAM bank can be positioned by the memory controller 106 by using a corresponding row and column decoder. A plurality of DRAM banks may form a DRAM chip (which may also be referred to as a memory chip), and a plurality of DRAM chips may form a DRAM rank. A plurality of DRAM ranks may be integrated into a dual in-line memory module (DIMM). For example, as shown in FIG. 1, the DRAM 108 may include a plurality of channels 110. Each channel 110 may include at least one rank, and each rank may include at least one bank. Each bank includes a plurality of storage units for storing data. A person skilled in the art may know that, a rank is memory chips connected to a same chip select signal. The memory controller can perform a write operation on chips in a same rank, and chips in a same rank share a same control signal. The memory controller 106 may separately access data in storage units in each channel in the DRAM 108 through a memory bus.

A person skilled in the art may know that, a refresh cycle of a DRAM chip is associated with a retention time of each storage unit in the DRAM chip. Currently, standard refresh cycles of commonly seen DRAM chips are all fixed. Generally, a standard refresh cycle is 64 ms. In a prior-art refresh solution, a memory controller checks, at intervals of a tREFI time, whether a rank needs to be refreshed. Each refresh needs to consume a tRFC time. tREFI is an average refresh interval of a memory. In other words, tREFI is used to indicate an average interval at which the memory controller sends a refresh command. tREFI may be determined based on a refresh cycle and a quantity of refresh commands to be sent in a refresh cycle. For example, tREFI may be 64 ms/8192 = 7.8 µs, where 64 ms is a refresh cycle, and 8192 is a quantity of refresh commands to be sent in a refresh cycle. tRFC is a row refresh cycle time. In other words, tRFC is used to indicate a time required for executing one refresh command in a DRAM rank. Generally, a longer tREFI indicates a larger tRFC; a shorter tREFI indicates a smaller tRFC. Within a tRFC time in a refresh process, a rank being refreshed cannot respond to a request for the rank. Therefore, a refresh frequency may be adjusted to mitigate impact caused on system performance by a refresh.

A person skilled in the art may know that, different refresh modes have different refresh frequencies. The double data rate (DDR) protocol specifies three refresh modes: a 1X mode, a 2X mode, and a 4X mode. In the 1X mode, refresh operations are performed on a memory chip at intervals of tREFI (base) specified in the DDR protocol, and a time for executing one refresh request is tRFC1. In the 2X mode, refresh operations are performed on a memory chip at intervals of tREFI (base)/2, and a time for executing one refresh request is tRFC2. In the 4X mode, refresh operations are performed on a memory chip at intervals of tREFI (base)/4, and a time for executing one refresh request is tRFC3. tRFC1 > tRFC2 > tFRC3. tREFI (base) is used to indicate a standard average refresh interval defined in the DDR protocol with which the computer system complies. Usually, tREFI (base) is used to indicate tREFI in the 1X mode in a condition that a DRAM chip surface temperature is within a normal temperature range (0°C to 85°C). According to the DDR4 standard, values of tREFI and tRFC may be set depending on an actual status. For example, for a DRAM chip having a capacity of 8 Gb, in a 1X configuration, tREFI may be 7.8 µs, and tRFC may be 350 ns. In a 4X configuration, tREFI may be 1.95 µs, and tRFC may be 160 ns. Dynamic refresh mode adjustment is supported in the DDR4 protocol. According to the DDR4 protocol, in a memory refresh process, a memory refresh mode may be switched from one to another among the 1X mode, the 2X mode, and the 4X mode.

As described above, in the prior art, a memory controller checks, at intervals of a tREFI time, whether a rank needs to be refreshed. If the rank is in an idle state, the memory controller refreshes the rank; if the rank is not in an idle state, the memory controller postpones refreshing the rank. When a postponement time exceeds a threshold, the memory controller forcibly refreshes the rank. However, when traffic in the memory is relatively heavy, a rank is seldom in an idle state, and it is possible that the rank cannot be in an idle state. If the rank is refreshed only after the rank is idle, a refresh needs to be continually postponed. At last, when a refresh needs to be performed to avoid a data loss, not only a refresh that should be performed within a current time period needs to be performed, but also a make-up refresh for a previously postponed refresh needs to be performed. Therefore, a relatively large quantity of refreshes are caused within a time period requiring a make-up refresh. In this case, a refresh needs to be performed even if an average refresh interval tREFI is not reached. In other words, when a make-up refresh needs to be performed, an increase in passive refreshes is caused. Because a response to a request for accessing the rank cannot be made in time during a refresh, when there are a relatively large quantity of passive refreshes, an interruption time of an access service increases. Consequently, the processor may stall, or operate in lower efficiency. In this case, system performance is more impacted, and relatively high refresh overheads are caused.

A person skilled in the art may know that, refresh operations on ranks in the memory 108 are independent. In a research process, it was found that, in a process of refreshing a DRAM, a rank being refreshed cannot respond to a request in the refresh process, resulting in refresh overheads of a system; furthermore, in the refresh process, requests for the rank being refreshed congest a scheduling queue, causing that a request for another rank cannot enter the scheduling queue to be sent to the another rank in time. This is also a cause affecting overall system performance. Moreover, in the refresh process, different refresh modes have different refresh frequencies, and different refresh frequencies result in different bus utilization rates. Therefore, in the refresh process, refresh mode selection also affects system performance.

To reduce refresh overheads of the computer system, and improve overall performance of the computer system in a refresh process, an embodiment of the present invention provides a memory refresh method, so as to improve a memory scheduling policy, and avoid a failure in execution of a request for another rank due to congestion of refresh operations on a scheduling queue. Moreover, a system bus utilization rate may be further improved by dynamically adjusting a refresh frequency. The following describes in detail a memory refresh solution in the computer system provided in this embodiment of the present invention with reference to FIG. 1.

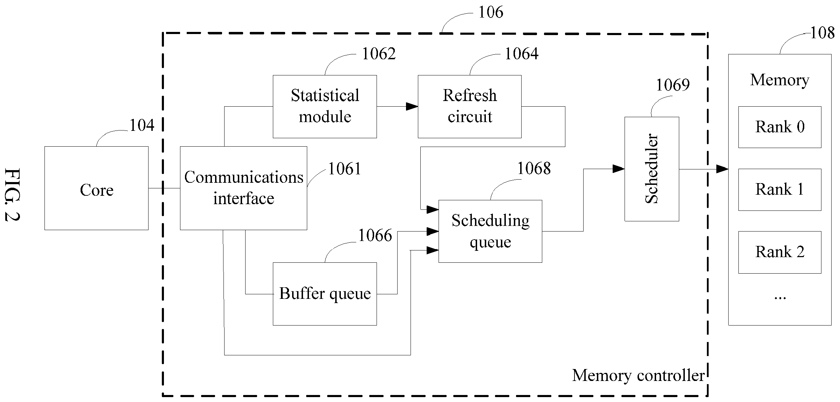

FIG. 2 is a schematic structural diagram of a memory controller 106 according to an embodiment of the present invention. For clear description, FIG. 2 also schematically shows connections between the memory controller 106 and a processor core 104 and between the memory controller 106 and a memory 108. The memory 108 may include a plurality of ranks such as a rank 0, a rank 1, and a rank 2. As shown in FIG. 2, the memory controller 106 may include a communications interface 1061, a statistical module 1062, a refresh circuit 1064, a buffer queue 1066, a scheduling queue 1068, and a scheduler 1069.

In this embodiment of the present invention, the communications interface 1061 in the memory controller 106 may include a front-end interface connected to a processor 102 in a computer, and may also include a back-end interface connected to the memory 108. Specifically, the memory controller 106 may receive, through the communications interface 1061, an access request sent by a processor (for example, a core 104 in FIG. 1) in a computer system. Through the communications interface 1061, the memory controller 106 may store data into the memory 108 or read data from the memory 108.

The statistical module 1062 may include statistical functions in two aspects. First, the statistical module 1062 may be configured to collect statistics on a distribution of target ranks of access requests received by the memory controller 106 and operation types of the access requests. The target rank is a rank to be accessed by using an access request. The operation types of the access requests may include types such as read operation and write operation. Specifically, the statistical module 1062 may collect statistics on target ranks of access requests, and obtain operation types in the access requests. Second, the statistical module 1062 may further collect statistics on a quantity of the access requests received by the memory controller 106. Specifically, the statistical module 1062 may collect statistics on a quantity of access requests for each to-be-accessed rank and a total quantity of access requests received by the memory controller 106. The statistical module 1062 may collect statistics based on access requests buffered in the buffer queue 1066 and the scheduling queue 1068. During actual application, the statistical module 1062 may be implemented by a counter. In other words, the statistical module 1062 may include one or more counters. In this embodiment of the present invention, the access request is a request of the processor for accessing the memory. The access request may include a read request, a write request, and the like. In other words, the processor may read data from the memory or write data to the memory according to the access request.

The refresh circuit 1064 is configured to determine, at an interval of a tREFI time based on a statistical result of the statistical module 1062, whether to generate a refresh request, and put the generated refresh request into the scheduling queue. For example, when the statistical module 1062 obtains, through statistics collection, that a quantity of access requests for a rank is less than a specified threshold, the refresh circuit 1064 may generate a refresh request for the rank, and put the refresh request into the scheduling queue 1068. It may be understood that, during actual application, the refresh request generated by the refresh circuit 1064 may alternatively be directly sent to the scheduler 1069, so that the scheduler 1069 sends the generated refresh request to the memory 108, and the memory 108 performs a refresh operation on the corresponding rank according to the generated refresh request. It should be noted that, tREFI is used to indicate an average refresh interval. During actual application, the refresh circuit 1064 may alternatively generate a refresh request at an interval less than tREFI. For example, when a make-up refresh needs to be performed, the refresh circuit 1064 may generate a refresh request at an interval less than tREFI. In addition, a person skilled in the art may know that tREFI varies with different refresh modes.

The buffer queue 1066 is configured to: in a process of performing a refresh operation on a rank, buffer an access request, sent by the core 104, for the rank. For example, the rank 0 in the memory 108 is used as an example. In a process of performing a refresh operation on the rank 0, if the memory controller 106 receives a read request from the core 104 for the rank 0, the read request may be buffered in the buffer queue 1066, rather than the scheduling queue 1068. During actual application, a scheduling priority may be further set for an access request in the buffer queue 1066. For example, some access requests may be set to be preferential scheduling or normal scheduling.

The scheduling queue 1068 is configured to buffer operation requests such as an access request sent by the core 104 and a refresh request sent by the refresh circuit 1064. The scheduler 1069 is configured to send the operation request (including at least the access request and the refresh request) in the scheduling queue 1068 to the memory 108, so as to implement an operation, for example, accessing or refreshing the memory 108. In this embodiment of the present invention, the buffer queue 1066 is an upfront buffer of the scheduling queue 1068. In this manner, the buffer queue 1066 may be configured to buffer an access request that is to enter the scheduling queue 1068. In this embodiment of the present invention, for convenient description, that two levels of buffers including the buffer queue 1066 and the scheduling queue 1068 are configured is used as an example in this embodiment of the present invention. During actual application, more levels of buffers may be configured depending on a requirement. For example, more levels of buffer queues 1066 may be configured ahead of the scheduling queue 1068.

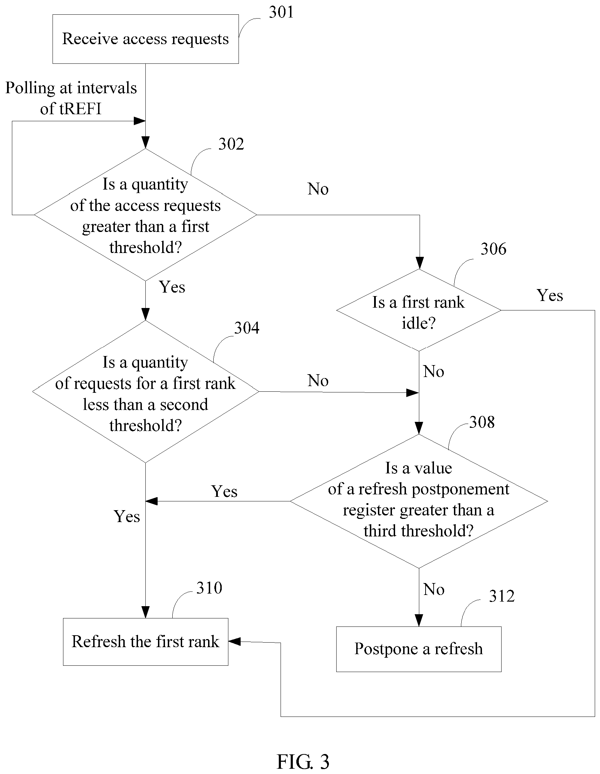

The following describes in detail a memory refresh method provided in an embodiment of the present invention with reference to FIG. 3. FIG. 3 is a flowchart of a memory refresh method according to an embodiment of the present invention. The memory refresh method shown in FIG. 3 may be performed by the memory controller 106 shown in FIG. 1 and FIG. 2. As shown in FIG. 3, the method may include the following steps.

In step 301, the memory controller 106 receives access requests sent by a core 104. In this embodiment of the present invention, the access request is a request used to access a memory 108. The memory controller 106 may read data from the memory 108 or write data to the memory 108 according to the access request. Operation types of the access requests may include types such as read operation and write operation. During actual application, through a communications interface 1061 between the memory controller 106 and the core 104, the memory controller 106 can receive the access request sent by the core 104.

In step 302, the memory controller 106 determines whether a quantity of the received access requests is greater than a first threshold. As described above, to avoid a data loss in the memory, the memory controller 106 checks, at intervals of a tREFI time, whether a rank needs to be refreshed. In this embodiment of the present invention, for convenient description, a process in which the memory controller 106 checks whether a rank needs to be refreshed is referred to as a refresh polling process. One tREFI time is referred to as a time period. In other words, the memory controller 106 performs refresh polling once at intervals of a tREFI time. Specifically, in one case, in a refresh polling process, the memory controller 106 may determine, based on a quantity, obtained by the statistical module 1062 through statistics collection, of to-be-processed access requests buffered in the memory controller 106, whether the quantity of the access requests is greater than the first threshold. In another case, the memory controller 106 may determine, based on a quantity, obtained by the statistical module 1062 through statistics collection, of access requests received by the memory controller 106 within a specified time period, whether the quantity of the access requests is greater than the first threshold. The specified time period may be a time period not greater than tREFI. The first threshold is greater than 0. The first threshold may be preset based on a magnitude of traffic during actual application. For example, the first threshold may be set to 100. When the quantity of the access requests received by the memory controller 106 is greater than the first threshold, indicating that there are a relatively large quantity of access requests, the method goes to step 304. When the quantity of the access requests received by the memory controller 106 is not greater than the first threshold, the method goes to step 306.

In step 304, the memory controller 106 determines whether a quantity of access requests for a to-be-accessed first rank is greater than a second threshold. The first rank may be any rank in the memory 108. In this embodiment of the present invention, the memory controller 106 may determine, based on a quantity, obtained by the statistical module 1062 through statistics collection, of access requests for the first rank, whether the quantity of the access requests for the first rank is less than the second threshold. The second threshold may be specifically set depending on an application scenario, and the second threshold is greater than 1. For example, the second threshold may be set to 20. When the quantity of the access requests for accessing the first rank is less than the second threshold, the method goes to step 310. When the quantity of the access requests for accessing the first rank is greater than the second threshold, the method goes to step 308. It should be noted that, the quantity of the access requests for the first rank may be a quantity of access requests for the first rank that are received by the memory controller 106 within the time period specified in step 302, or may be a quantity of to-be-processed access requests for the first rank that are buffered in the memory controller 106.

In step 306, the memory controller 106 determines whether a first rank is in an idle state. Specifically, when in step 302, the memory controller 106 determines that the quantity of the received access requests is greater than the first threshold, it indicates that the entire memory has relatively heavy access traffic, and in this case, the memory controller 106 needs to further determine whether the first rank needs to be refreshed. If the first rank is in an idle state, in other words, if the quantity of the access requests for accessing the first rank that are in the scheduling queue of the memory controller is 0, the method goes to step 310. If the first rank is not in an idle state, in other words, if the quantity of the access requests for accessing the first rank that are in the scheduling queue of the memory controller is not 0, the method goes to step 308.

In step 308, the memory controller 106 determines whether a quantity of postponed refreshes on the first rank is greater than a specified third threshold. When the memory controller 106 determines that the quantity of the postponed refreshes on the first rank is greater than the third threshold, the method goes to step 310. When the memory controller 106 determines that the quantity of the postponed refreshes on the first rank is not greater than the third threshold, the method goes to step 312. In this embodiment of the present invention, the third threshold is not less than 1 and is less than a specified warning value. The warning value may be determined based on a maximum quantity of refresh commands that can be postponed for the rank (postponing refresh commands). For example, according to the DDR4 protocol, a maximum of eight refresh commands can be postponed for a rank; in other words, the warning value is 8, and the third threshold needs to be less than 8. For example, the third threshold may be set to 6.

In this embodiment of the present invention, a postponement register (not shown in FIG. 2) may be disposed in the refresh circuit 1064, and the postponement register may be configured to collect statistics on the quantity of the postponed refreshes on the first rank. During actual application, the postponement register may alternatively be disposed independent of the refresh circuit 1064. In another case, a postponement register may be not disposed, and instead, the quantity of the postponed refreshes on the first rank is obtained by using software through statistics collection. In this embodiment of the present invention, no limitation is imposed on a manner how the quantity of the postponed refreshes on the first rank is specifically obtained through statistics collection.

In step 310, the memory controller 106 refreshes the first rank. Specifically, in one case, the refresh circuit 1064 in the memory controller 106 may generate a refresh request according to a default refresh mode. In another case, the refresh circuit 1064 in the memory controller 106 may determine a refresh mode based on the quantity of the access requests, types of the access requests, and a distribution of target ranks that are obtained by the statistical module 1062 through statistics collection, and generate a refresh request according to the determined refresh mode, to refresh the first rank according to the generated refresh request.

As described above, the double data rate (DDR) protocol specifies three refresh modes: a 1X mode, a 2X mode, and a 4X mode. In this embodiment of the present invention, the refresh mode may include at least a first refresh mode and a second refresh mode. In the first refresh mode, the memory controller performs refreshes at intervals of tREFI (base)/N. In the second refresh mode, the memory controller performs refreshes at intervals of tREFI (base). For example, the first refresh mode may be the 4X or 2X mode, and the second refresh mode may include the 1X mode. tREFI (base) is used to indicate a standard average refresh interval defined in the DDR protocol, and N is an integer greater than 1. Usually, tREFI (base) is used to indicate tREFI in the 1X mode in a condition that a DRAM chip surface temperature is within a normal temperature range (0°C to 85°C). For convenient description, tREFI (base) may also be denoted by T in this embodiment of the present invention.

For a memory system, a decrease in a refresh frequency is of more significance to system performance improvement than a decrease in postponed refreshes. Therefore, usually, performing refreshes in the 4X mode results in lower system performance than performing refreshes in the 1X mode. Moreover, when a proportion of high read requests or write requests in the access requests is relatively high, the memory 108 has a relatively high bandwidth utilization rate due to a relatively small quantity of switches between read and write. However, in a process of implementing the present invention, it is found that, because the DDR protocol specifies a four active window (tFAW), when there are a relatively small quantity of to-be-accessed target ranks for a plurality of access requests, in other words, when a plurality of access requests concentrate on a relatively small quantity of ranks in the memory 108, in the tFAW time window, a quantity of rows in one rank that are simultaneously operatable is limited, and therefore overall system performance decreases, instead. tFAW means that within the tFAW time window, one rank allows a maximum of four row active commands to be sent. Take two ranks in the memory 108 as an example. When a proportion of read requests or write requests is relatively high and access requests concentrate on one of the ranks, the other rank is being refreshed. A longer refresh time indicates longer single-rank access duration, and a larger decrease in overall system performance.

In a process of implementing the present invention, it is found that, in comparison between the 4X mode and the 1X mode, because a single refresh time tRFC3 for a refresh in the 4X mode is relatively small, in a single refresh process, impact caused on a system by a tFAW limitation is relatively small, and a decrease in overall system performance is relatively small. Therefore, in this embodiment of the present invention, to improve overall system performance, and reduce the tFAW limitation on the system, a refresh mode is dynamically adjusted in this embodiment of the present invention. Specifically, in one case, when the refresh circuit 1064 determines, based on a statistical result of the statistical module 1062, that a quantity of to-be-accessed target ranks of the access requests is less than a specified fourth threshold and a proportion of read requests or write requests in the access requests is greater than a specified fifth threshold, the refresh circuit 1064 may determine to refresh the first rank in the 4X mode. In other words, when the to-be-accessed target ranks of the access requests received by the memory controller 106 are relatively concentrated and the proportion of read requests or write requests is relatively high, the first rank may be refreshed in the 4X mode. During actual application, the fourth threshold may be determined based on a total quantity of ranks in the memory 108. For example, when the memory 108 includes four ranks, the fourth threshold may be set to 2. The fifth threshold may be 60%. It may be understood that, in this embodiment of the present invention, a target rank is a rank to be accessed by using an access request. A quantity of target ranks is a quantity of ranks to be accessed by using access requests.

In another case, if to-be-accessed target ranks of the access requests received by the memory controller 106 are relatively scattered, or a proportion of read requests or write requests in the access requests received by the memory controller 106 is not greater than a fifth threshold, the refresh circuit 1064 may refresh the first rank in the 1X mode. It may be understood that, in this embodiment of the present invention, the fourth threshold is greater than 0, and the fourth threshold is less than the total quantity of ranks in the memory 108. During actual application, the fourth threshold may be determined based on the total quantity of ranks in the memory 108. For example, the fourth threshold may be set to a half of a total quantity of all ranks in a DRAM. The fifth threshold may be set to a relatively high proportion. For example, when the proportion of read requests is measured by a proportion of a quantity of read requests in the total quantity of the received access requests, the fifth threshold may be 60%.

In this embodiment of the present invention, the proportion of read requests is used to indicate a proportion of read requests in the received access requests. The proportion of write requests is used to indicate a proportion of write requests in the received access requests. For example, the proportion of read requests may be represented by a proportion of a quantity of read requests in the total quantity of the access requests. The proportion of write requests may be represented by a proportion of a quantity of write requests in the total quantity of the access requests. During actual application, the proportion of read requests may be represented by a ratio of a quantity of read requests to a quantity of write requests. The write requests may be represented by a ratio of a quantity of write requests to a quantity of read requests. No limitation is imposed herein provided that the proportion of read requests or write requests can be determined.

In step 310, after the refresh circuit 1064 determines the refresh mode, the refresh circuit 1064 generates a corresponding refresh request according to the determined refresh mode (for example, the 1X mode or the 4X mode), and puts the generated refresh request into the scheduling queue 1068 (as shown in FIG. 2), so that the scheduler 1069 may send the refresh request to the memory 108, and the memory 108 may perform a refresh operation on the first rank according to the refresh request generated by the memory controller 106. During actual application, after generating the refresh request, the refresh circuit 1064 may alternatively directly send the generated refresh request to the scheduler 1069, and the scheduler 1069 sends the generated refresh request to the first rank.

It may be understood that, when the memory controller 106 determines that a refresh operation needs to be performed on the first rank, if the memory controller 106 is executing an access request for the first rank, or the scheduling queue still has an access request for the first rank, the memory controller 106 may send the refresh request only after both the access request being executed for the first rank and the access request for the first rank in the scheduling queue are processed, to avoid affecting system performance.

In step 312, the memory controller 106 postpones a refresh operation on the first rank. Specifically, when in step 308, the memory controller 106 determines that a quantity of postponed operations on the first rank is not greater than the third threshold, the memory controller postpones the refresh operation on the first rank, and adds 1 to a value of the postponement register. In other words, when the memory controller 106 determines through step 306 that the first rank is not in an idle state, that is, when an access request for the first rank is being processed or the scheduling queue still includes an access request for the first rank, if a quantity of postponements for the first rank does not reach the third threshold, it may be considered that there are a relatively large quantity of access requests for the first rank. To avoid affecting performance, the refresh operation is not performed on the first rank, so as to perform the refresh operation on the first rank in a subsequent polling process. As described above, the third threshold is not less than 1 and is less than a specified warning value. The warning value may be determined based on a maximum quantity of refresh commands that can be postponed for the first rank. The warning value is used to indicate a need to immediately perform a refresh operation on the first rank. In other words, the warning value is used to instruct the memory controller 106 to forcibly perform a refresh operation on the first rank.

It may be understood that, when a refresh operation is forcibly performed on the first rank, a make-up refresh needs to be performed for a previously postponed refresh. Therefore, a relatively large quantity of refreshes are caused within a time period requiring a make-up refresh. Within a particular make-up refresh time period, in one aspect, a failure to execute an access request, put into the scheduling queue, for the first rank may be caused; consequently, space of the scheduling queue 1068 is occupied for a relatively long time, and an access request for another rank cannot enter the scheduling queue, affecting performance of the entire computer system. In another aspect, a system service may be interrupted due to an increase in refreshes within a short time. In short, forcibly refreshing the first rank increases refresh power consumption of the computer system 100, and affects system performance.

In conclusion, in the refresh method provided in this embodiment of the present invention, in one tREFI polling process, the following several cases may exist with respect to the refresh operation on the first rank.

Case 1: When the quantity of the access requests received by the memory controller 106 is greater than the first threshold and the quantity of the access requests for accessing the first rank is less than the second threshold, the memory controller 106 directly performs the refresh operation on the first rank. In other words, when access traffic of the computer system 100 is relatively heavy, provided that the quantity of the access requests for accessing the first rank is relatively small, the memory controller 106 may actively perform the refresh operation on the first rank, instead of performing the refresh operation on the first rank only after the first rank is in an idle state. This is because when the access traffic of the computer system 100 is relatively heavy, the first rank is very unlikely to be in an idle state, and if a refresh is continually postponed, during a subsequent forcible refresh to avoid a data loss, an increase in passive refreshes may be caused within a particular time. Such an active refresh manner provided in this embodiment of the present invention can mitigate impact caused on computer system performance by an increase in passive refreshes caused by refresh postponements, and improve memory refresh flexibility. Therefore, computer system performance can be improved, and refresh overheads can be reduced. Certainly, it may be understood that, in this embodiment of the present invention, that the quantity of the access requests for accessing the first rank is less than the specified second threshold includes a case in which the first rank is idle.

Case 2: When the quantity of the access requests received by the memory controller 106 is greater than the first threshold, the quantity of the access requests for accessing the first rank is not less than the second threshold, and the quantity of the postponed refreshes on the first rank is greater than the third threshold, the memory controller 106 directly performs the refresh operation on the first rank. In other words, when memory access traffic in the computer system 100 is relatively heavy and the quantity of the access requests for the first rank is also relatively large, if the quantity of the postponements for the first rank is greater than the third threshold, the refresh operation needs to be immediately performed on the first rank, so as to avoid a possibility of a need to perform a forcible refresh because the quantity of the postponed refreshes on the first rank reaches the warning value, and mitigate impact caused on computer system performance by a relatively large quantity of passive refreshes, thereby improving memory refresh flexibility. It may be understood that, the third threshold is a threshold specified with reference to the warning value during actual application, so that the computer system can postpone a refresh within a specific range without affecting performance, thereby improving memory refresh flexibility.

Case 3: When the quantity of the access requests received by the memory controller 106 is greater than the first threshold, the quantity of the access requests for accessing the first rank is not less than the second threshold, and the quantity of the postponed refreshes on the first rank is not greater than the third threshold, the refresh operation on the first rank may be postponed. In other words, in this embodiment of the present invention, when memory access traffic in the computer system 100 is relatively heavy and the quantity of the access requests for the first rank is also relatively large, provided that the quantity of the postponed refreshes on the first rank has not reached the preset third threshold, to avoid affecting processing on an access request for the first rank in the scheduling queue1068, the refresh operation on the first rank may be postponed.

Case 4: When the quantity of the access requests received by the memory controller 106 is not greater than the first threshold and the first rank is in an idle state, the memory controller 106 may directly perform the refresh operation on the first rank. In other words, when memory traffic of the computer system 100 is relatively light and the first rank is in an idle state, the refresh operation on the first rank causes relatively small impact on computer system performance. Therefore, the refresh operation may be directly performed on the first rank.

Case 5: When the quantity of the access requests received by the memory controller 106 is not greater than the first threshold, the first rank is not in an idle state, and the quantity of the postponed refreshes on the first rank is greater than the third threshold, the memory controller 106 needs to actively perform the refresh operation on the first rank. In other words, when memory traffic of the computer system 100 is relatively light but the first rank is relatively busy, to avoid a forcible refresh on the first rank, the refresh operation needs to be performed on the first rank in the current polling process, so as to avoid an increase in passive refreshes on the system because the quantity of the postponed refreshes reaches the warning value, and mitigate impact on computer system performance by the passive refreshes.

Case 6: When the quantity of the access requests received by the memory controller 106 is not greater than the first threshold, the first rank is not in an idle state, and the quantity of the postponed refreshes on the first rank is not greater than the third threshold, the memory controller 106 may postpone the refresh operation on the first rank. In other words, when memory traffic of the computer system 100 is relatively light but the first rank is relatively busy, to process access requests for the first rank as many as possible, when the quantity of the postponements for the first rank is still not greater than the third threshold, the refresh operation on the first rank may be postponed.

It may be understood that, all the above descriptions about the memory refresh method provided in this embodiment of the present invention are made by using the refresh operation on the first rank in the memory 108 in one refresh polling process as an example. During actual application, in each refresh polling process, the memory controller may determine, according to the method provided above, whether different ranks need to be refreshed. For example, in a first refresh polling process, the memory controller 106 may determine to refresh the first rank according to case 1, refresh a second rank in the memory 108 according to case 2, and postpone a refresh operation on a third rank in the memory 108 according to case 3. In a second refresh polling process, the memory controller 106 may postpone refreshing the first rank according to case 6, and refresh the second rank according to case 5.

Further, the memory controller 106 cannot respond to an access request for the first rank either within the tRFC time period in which the refresh operation is being performed on the first rank. Therefore, to prevent the access request for the first rank from congesting the scheduling queue 1068, causing that an access request for another rank (for example, the second rank) cannot enter the scheduling queue 1068 and affecting system performance, in this embodiment of the present invention, when the refresh operation is being performed on the first rank, if the memory controller 106 receives an access request for the first rank, the memory controller 106 may put the access request for the first rank into the buffer queue 1066. After the memory controller 106 performs the refresh operation on the first rank, the access request for the first rank in the buffer queue 1066 is put from the buffer queue 1066 into the scheduling queue 1068. Moreover, in this embodiment of the present invention, after performing the refresh operation on the first rank, the memory controller 106 may directly put a subsequently newly received access request for the first rank into the scheduling queue 1068 rather than the buffer queue 1066.

It may be understood that, in this embodiment of the present invention, when the refresh operation is being performed on the first rank, if no refresh operation is being performed on the second rank in the memory 108, the memory controller 106 may directly put a received access request for the second rank into the scheduling queue 1068. In this scheduling manner, target ranks of access requests in the scheduling queue may be distributed in a scattered manner, so that in a process of performing the refresh operation on the first rank, the memory controller 106 can process access requests for different ranks as many as possible, so as to reduce system overheads of the computer system 100 in a refresh operation process, and improve execution efficiency of the computer system 100.

It may be learned from the refresh method provided in this embodiment of the present invention that, in this embodiment of the present invention, to mitigate impact caused on computer system performance by a memory refresh process, both a status of the access requests received by the system and a status of a to-be-accessed target rank are comprehensively considered for determining whether the target rank needs to be refreshed. In this way, by managing a refresh time of the memory controller, on a basis of compatibility with the existing DDR protocol, impact on performance of the computer system by an increase in passive refreshes caused by refresh postponements is mitigated, memory refresh flexibility is improved, and refresh overheads are reduced. Moreover, in this embodiment of the present invention, when the refresh operation needs to be performed on the first rank, a different refresh mode may be further selected based on a distribution of target ranks and a type distribution of the access requests, to improve refresh efficiency of the memory controller, and improve performance of the computer system.

Further, in this embodiment of the present invention, to improve concurrency of access requests, so that the refresh operation on the first rank does not affect processing on an access request for another rank, a plurality of buffer levels may be configured in the memory controller. For example, the scheduling queue and the buffer queue may be separately configured. In this way, an access request for the first rank that is received within the tRFC time period in which the refresh operation is being performed on the first rank may be buffered in the buffer queue, so as to prevent the access request for the first rank that is received within the tRFC time period from congesting the scheduling queue and from affecting processing of the memory controller on the access request for the another rank. Processing efficiency of the entire computer system is further improved.

It should be noted that, during actual application, each step in the embodiment shown in FIG. 3 is not necessarily performed. For example, the memory refresh method is described with reference to a magnitude of access traffic in the entire system in the embodiment shown in FIG. 3, for example, in a polling process, step 302 may be first performed to determine whether the quantity of the access requests received by the memory controller 106 is greater than the first threshold. However, during actual application, a magnitude of access traffic in the entire system may be not differentiated, but instead, processing is directly performed based on an access traffic status of a to-be-refreshed rank. In this case, step 302 in the embodiment of FIG. 3 is not necessary. In other words, the refresh method provided in this embodiment of the present invention can be used in both a case of heavy access traffic of a system and a case of light access traffic of a system. No limitation is imposed herein.

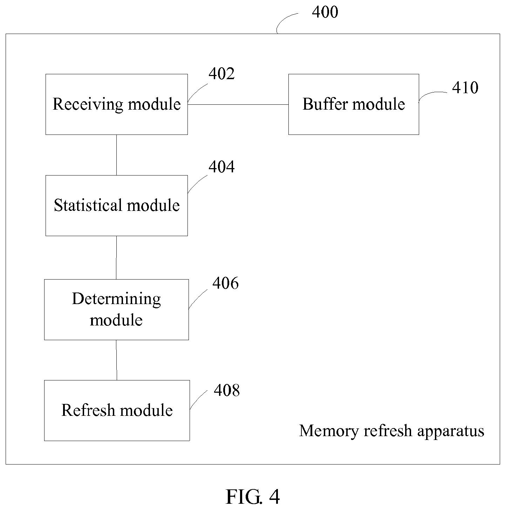

FIG. 4 is a schematic structural diagram of a memory refresh apparatus according to an embodiment of the present invention. The memory refresh apparatus 400 is configured to refresh the memory 108 shown in FIG. 1. As shown in FIG. 4, the memory refresh apparatus 400 may include a receiving module 402, a statistical module 404, a determining module 406, and a refresh module 408.

The receiving module 402 is configured to receive access requests. Specifically, the receiving module 402 may receive access requests sent by one or more cores 104 in a computer system 100. It may be understood that, the receiving module 402 may be further configured to receive data returned by the memory 108. The receiving module 402 specifically includes a communications interface between a memory controller 106 and the core 104, and a communications interface between the memory controller 106 and the memory 108.

The statistical module 404 is configured to collect statistics on a quantity of the access requests received by the receiving module 402. During actual application, the statistical module 404 may further collect statistics on a quantity of access requests for accessing each rank.

The determining module 406 is configured to determine whether a quantity of access requests for accessing a first rank that are in the received access requests is greater than 0 and less than a second threshold. The first rank is any rank in the memory. During actual application, the determining module 406 may perform determining based on a statistical result of the statistical module 404.

The refresh module 408 is configured to refresh the first rank when the quantity of the access requests for accessing the first rank that are in the received access requests is greater than 0 and less than the second threshold. As described above, during actual application, in one case, the refresh module 408 may generate a refresh request according to a specified refresh mode, and refresh the first rank according to the generated refresh request. In another case, the refresh module 408 may dynamically determine a refresh mode based on the quantity of the access requests and a distribution of to-be-accessed target ranks that are obtained by the statistical module 404 through statistics collection, and generate a refresh request according to the determined refresh mode, to refresh the first rank according to the generated refresh request. Specifically, the refresh module 408 may send the generated refresh request to the memory 108, so that the memory 108 can refresh the first rank according to the refresh request.

In a possible case, the determining module 406 is further configured to determine whether a quantity of target ranks of the received access requests is less than a specified fourth threshold, and whether a proportion of read requests or write requests in the access requests is greater than a specified fifth threshold. The refresh module 408 is configured to refresh the first rank at a T/N interval when the quantity of the target ranks of the received access requests is less than the specified fourth threshold, and the proportion of read requests or write requests in the access requests is greater than the specified fifth threshold. T is used to indicate a standard average refresh interval, and N is an integer greater than 1. Specifically, the refresh module 408 may generate a first refresh request according to a first refresh mode, and refresh the first rank according to the generated first refresh request. In the first refresh mode, the memory controller refreshes the first rank at the T/N interval. During actual application, T may be tREFI (base) specified in the DDR protocol.

In a possible case, the memory refresh apparatus 400 may further include a buffer module 410. The buffer module 410 is configured to buffer the access requests received by the receiving module 402 in a buffer queue or a scheduling queue. During actual application, the buffer module 410 may include the buffer queue and the scheduling queue. The buffer queue is an upfront queue of the scheduling queue.

In a possible case, the receiving module 402 is further configured to: in a process of refreshing the first rank, receive a first access request for accessing the first rank. The buffer module 410 is configured to buffer the first access request in a configured buffer queue. The buffer module 410 includes the buffer queue and a scheduling queue, the buffer queue is used to buffer a newly received access request for a rank on which a refresh operation is being performed, and the scheduling queue is used to buffer an access request to be sent to a rank on which a refresh operation is not being performed.

In another possible case, the receiving module 402 is further configured to receive a second access request for accessing a second rank in a DRAM. The buffer module 410 is further configured to buffer the second access request in the configured scheduling queue when no refresh operation is being performed on the second rank.

Optionally, the determining module 406 is further configured to determine whether a quantity of access requests for accessing the second rank in the DRAM that are in the received access requests is less than the second threshold. The refresh module 408 is further configured to refresh the second rank when the quantity of the access requests for accessing the second rank in the DRAM that are in the received access requests is not less than the second threshold and a quantity of postponed refreshes on the second rank is greater than a specified third threshold. The third threshold is not less than 1 and is less than a specified warning value, and the warning value is used to indicate a need to immediately perform a refresh operation on the second rank.

In another possible case, the determining module 406 is further configured to determine whether a quantity of access requests for accessing a third rank in the DRAM that are in the received access requests is less than the second threshold. The refresh module 408 is further configured to skip performing a refresh operation on the third rank when the quantity of the access requests for accessing the third rank in the DRAM that are in the received access requests is not less than the second threshold and a quantity of postponed refreshes on the third rank is not greater than the specified third threshold, where the third threshold is not less than 1 and is less than the specified warning value, and the warning value is used to indicate a need to immediately perform a refresh operation on the third rank.

In another possible case, the determining module 406 is further configured to determine whether a quantity of target ranks of the received access requests is less than a specified fourth threshold, and whether a proportion of read requests or write requests in the access requests is greater than a specified fifth threshold. The refresh module 408 is further configured to refresh the first rank when the quantity of the target ranks of the received access requests is not less than the specified fourth threshold and the proportion of read requests or write requests in the access requests is not greater than the specified fifth threshold, which specifically includes: refreshing the first rank at a T interval, where T is used to indicate a standard average refresh interval.

In another possible case, the refresh module 408 is further configured to skip performing a refresh operation on the second rank when the quantity of the access requests for accessing the second rank in the DRAM that are in the received access requests is greater than 0 and less than the specified second threshold and the quantity of the postponed refreshes on the second rank is not greater than the specified third threshold, where the third threshold is not less than 1 and is less than the specified warning value, and the warning value is used to indicate a need to immediately perform a refresh operation on the second rank.

In another possible case, the refresh module 408 is further configured to refresh the third rank when the quantity of the access requests for accessing the third rank in the DRAM that are in the received access requests is greater than 0 and the quantity of the postponed refreshes on the third rank is greater than the specified third threshold, where the third threshold is not less than 1 and is less than the specified warning value, and the warning value is used to indicate a need to immediately perform a refresh operation on the third rank.

It may be understood that, modules in the memory refresh apparatus 400 shown in FIG. 4 may be separately located in one or more components in the memory controller shown in FIG. 2. In this embodiment of the present invention, some or all of the modules in the embodiment shown in FIG. 4 may be selected depending on an actual requirement to achieve an objective of the solution in this embodiment. For content that is not described in detail in the embodiment of FIG. 4, refer to the related description in the method embodiment shown in FIG. 3.

It may be understood that the described apparatus embodiments are merely examples. For example, the module division is merely logical function division and may be other division in actual implementation. For example, a plurality of modules or components may be combined or integrated into another system, or some features may be ignored or not performed. In addition, connections between the modules discussed in the foregoing embodiments may be in electrical, mechanical, or other forms. The modules described as separate parts may or may not be physically separate, and parts displayed as modules may or may not be physical modules. In addition, function modules in the embodiments of this application may exist independently, or may be integrated into one processing module. For example, the function modules shown in FIG. 4 may be integrated into the memory controller

An embodiment of the present invention further provides a computer program product for data processing, including a computer readable storage medium storing program code, where instructions included in the program code are used to execute the method process described in any one of the foregoing method embodiments. A person of ordinary skill in the art may understand that the foregoing storage medium may include any non-transitory machine-readable medium capable of storing program code, such as a USB flash drive, a removable hard disk, a magnetic disk, an optical disc, a random-access memory (RAM), a solid state disk (SSD), or a non-volatile memory.

## Claims

1. A memory refresh method, wherein the method is applied to a computer system comprising a memory controller and a dynamic random access memory, DRAM, and the method comprises:
receiving (301), by the memory controller, access requests for accessing the DRAM, wherein the access requests for accessing the DRAM includes access requests for accessing a first rank of the DRAM;
determining (302), by the memory controller, whether a quantity of the received access requests for accessing the DRAM is greater than a first threshold;
if the quantity of the received access requests for accessing the DRAM is greater than the first threshold, determining (304), by the memory controller, whether a quantity of the access requests for accessing the first rank is greater than a second threshold; and
refreshing (310), by the memory controller, the first rank when a quantity of access requests for accessing the first rank is greater than 0 and less than the second threshold in one case at a standard average refresh interval, in another case, based on the quantity of the access requests, at a T/N interval, wherein T is the standard average refresh interval, and N is an integer greater than 1.

2. The memory refresh method according to claim 1, wherein the refreshing, by the memory controller, the first rank comprises:
refreshing, by the memory controller, the first rank at the T/N interval when a quantity of target ranks of the received access requests is less than a specified fourth threshold and a proportion of read requests or write requests in the access requests is greater than a specified fifth threshold, wherein the target ranks are ranks to be accessed by using the received access requests for accessing the DRAM.

3. The method according to claim 1 or 2, further comprising:
in a process in which the memory controller refreshes the first rank, receiving, by the memory controller, a first access request for accessing the first rank; and
buffering, by the memory controller, the first access request in a configured buffer queue, wherein the memory controller comprises at least the buffer queue and a scheduling queue, the buffer queue is used to buffer an access request for a rank on which a refresh operation is being performed, and the scheduling queue is used to buffer an access request to be sent to a rank on which a refresh operation is not being performed.

4. The method according to claim 3, further comprising:
receiving, by the memory controller, a second access request for accessing a second rank in the DRAM; and
buffering, by the memory controller, the second access request in the scheduling queue when the second rank is not being refreshed.

5. The method according to any one of claims 1 to 4, further comprising:
refreshing, by the memory controller, the second rank when a quantity of access requests for accessing the second rank in the DRAM that are in the received access requests is not less than the second threshold and a quantity of postponed refreshes on the second rank is greater than a specified third threshold, wherein the third threshold is not less than 1 and is less than a specified warning value, and the warning value is used to indicate a need to immediately perform a refresh operation on the second rank.

6. The method according to any one of claims 1 to 5, further comprising:
skipping, by the memory controller, performing a refresh operation on a third rank when a quantity of access requests for accessing the third rank in the DRAM that are in the received access requests is not less than the second threshold and a quantity of postponed refreshes on the third rank is not greater than the specified third threshold, wherein the third threshold is not less than 1 and is less than the specified warning value, and the warning value is used to indicate a need to immediately perform a refresh operation on the third rank.

7. The memory refresh method according to claim 1, wherein the refreshing, by the memory controller, the first rank comprises:
refreshing, by the memory controller, the first rank at a T interval when a quantity of target ranks of the received access requests is not less than a specified fourth threshold and a proportion of read requests or write requests in the access requests is not greater than a specified fifth threshold, wherein T is used to indicate a standard average refresh interval.

8. A computer system (100), comprising a memory controller (106) and a dynamic random access memory (108), DRAM, connected to the memory controller (106), wherein the memory controller (106) is configured to perform the method according to any one of claims 1-7.

9. A memory refresh apparatus (400), wherein the memory refresh apparatus (400) is configured to refresh a dynamic random access memory (108), DRAM, in a computer system (100), and comprises:
a receiving module (402), configured to receive access requests for accessing the DRAM, wherein the access requests for accessing the DRAM includes access requests for accessing a first rank of the DRAM;
a statistical module (404), configured to: determine whether a quantity of the received access requests for accessing the DRAM is greater than a first threshold, and if the quantity of the received access requests for accessing the DRAM is greater than the first threshold, determines whether a quantity of the access requests for accessing the first rank is greater than a second threshold; and
a refresh module (408), configured to refresh the first rank when a quantity of access requests for accessing the first rank in the DRAM that are in the received access requests is greater than 0 and less than the second threshold in one case at a standard average refresh interval, in another case, based on the quantity of the access requests, at a T/N interval, wherein T is the standard average refresh interval, and N is an integer greater than 1.

10. The memory refresh apparatus according to claim 9, wherein
the refresh module (408) is configured to refresh the first rank at the T/N interval when a quantity of target ranks of the received access requests is less than a specified fourth threshold and a proportion of read requests or write requests in the access requests is greater than a specified fifth threshold, wherein the target ranks are ranks to be accessed by using the received access requests for accessing the DRAM

11. The memory refresh apparatus according to claim 9, wherein
the receiving module (402) is further configured to: in a process of refreshing the first rank, receive a first access request for accessing the first rank; and
the memory refresh apparatus (400) further comprises:
a buffer module (410), configured to buffer the first access request in a configured buffer queue, wherein the buffer module comprises at least the buffer queue and a scheduling queue, the buffer queue is used to buffer an access request for a rank on which a refresh operation is being performed, and the scheduling queue is used to buffer an access request to be sent to a rank on which a refresh operation is not being performed.

12. The memory refresh apparatus according to claim 11, wherein
the receiving module (402) is further configured to receive a second access request for accessing a second rank in the DRAM; and
the buffer module (410) is further configured to buffer the second access request in the scheduling queue when the second rank is not being refreshed.

13. The memory refresh apparatus according to any one of claims 9 to 12, wherein
the refresh module (408) is further configured to refresh the second rank when a quantity of access requests for accessing the second rank in the DRAM that are in the received access requests is not less than the second threshold and a quantity of postponed refreshes on the second rank is greater than a specified third threshold, wherein the third threshold is not less than 1 and is less than a specified warning value, and the warning value is used to indicate a need to immediately perform a refresh operation on the second rank.

14. The memory refresh apparatus according to any one of claims 9 to 13, wherein
the refresh module (408) is further configured to skip refreshing a third rank when a quantity of access requests for accessing the third rank in the DRAM that are in the received access requests is not less than the second threshold and a quantity of postponed refreshes on the third rank is not greater than the specified third threshold, wherein the third threshold is not less than 1 and is less than the specified warning value, and the warning value is used to indicate a need to immediately perform a refresh operation on the third rank.

15. The memory refresh apparatus according to claim 9, wherein
the refresh module (408) is configured to refresh the first rank at a T interval when a quantity of target ranks of the received access requests is not less than a specified fourth threshold and a proportion of read requests or write requests in the access requests is not greater than a specified fifth threshold, wherein T is used to indicate a standard average refresh interval.

16. A computer readable storage medium, comprising one or more computer executable instructions, wherein when the one or more computer executable instructions are executed by a computer, the computer performs the method according to any one of claims 1-7.

## Patentansprüche

1. Speicherauffrischverfahren, wobei das Verfahren auf ein Computersystem angewandt wird, das einen Speichercontroller und einen dynamischen Direktzugriffsspeicher bzw. DRAM umfasst, und das Verfahren Folgendes umfasst:
Empfangen (301), durch den Speichercontroller, von Zugriffsanforderungen zum Zugreifen auf den DRAM, wobei die Zugriffsanforderungen zum Zugreifen auf den DRAM Zugriffsanforderungen zum Zugreifen auf einen ersten Rang des DRAM umfassen;
Bestimmen (302) durch den Speichercontroller, ob eine Quantität der empfangenen Zugriffsanforderungen zum Zugreifen auf den DRAM größer als eine erste Schwelle ist;
wenn die Quantität der empfangenen Zugriffsanforderungen zum Zugreifen auf den DRAM größer als die erste Schwelle ist, Bestimmen (304) durch den Speichercontroller, ob eine Quantität der Zugriffsanforderungen zum Zugreifen auf den ersten Rang größer als eine zweite Schwelle ist; und
Auffrischen (310) des ersten Rangs durch den Speichercontroller, wenn eine Quantität von Zugriffsanforderungen zum Zugreifen auf den ersten Rang größer als 0 und kleiner als die zweite Schwelle ist, in einem Fall in einem Standard-Durchschnittsauffrischintervall und in einem anderen Fall auf der Basis der Quantität der Zugriffsanforderungen in einem T/N-Intervall, wobei T das Standard-Durchschnittsauffrischintervall ist und N eine ganze Zahl größer als 1 ist.

2. Speicherauffrischverfahren nach Anspruch 1, wobei das Auffrischen des ersten Rangs durch den Speichercontroller Folgendes umfasst:
Auffrischen des ersten Rangs durch den Speichercontroller in dem T/N-Intervall, wenn eine Quantität von Zielrängen der empfangenen Zugriffsanforderungen kleiner als eine vorgegebene vierte Schwelle ist und ein Anteil von Leseanforderungen oder Schreibanforderungen in den Zugriffsanforderungen größer als eine vorgegebene fünfte Schwelle ist, wobei die Zielränge Ränge sind, auf die durch Verwendung der empfangenen Zugriffsanforderungen zum Zugreifen auf den DRAM zugegriffen werden soll.

3. Verfahren nach Anspruch 1 oder 2, ferner umfassend:
Empfangen, durch den Speichercontroller, einer ersten Zugriffsanforderung zum Zugreifen auf den ersten Rang in einem Prozess, in dem der Speichercontroller den ersten Rang auffrischt; und
Puffern der ersten Zugriffsanforderung in einer konfigurierten Pufferwarteschlange durch den Speichercontroller, wobei der Speichercontroller mindestens die Pufferwarteschlange und eine Einteilungswarteschlange umfasst, wobei die Pufferwarteschlange verwendet wird, um eine Zugriffsanforderung für einen Rang zu puffern, an dem gerade eine Auffrischoperation ausgeführt wird, und die Einteilungswarteschlange verwendet wird, um eine Zugriffsanforderung zu puffern, die zu einem Rang gesendet werden soll, an dem gerade keine Auffrischoperation ausgeführt wird.

4. Verfahren nach Anspruch 3, ferner umfassend:
Empfangen, durch den Speichercontroller, einer zweiten Zugriffsanforderung zum Zugreifen auf einen zweiten Rang in dem DRAM; und
Puffern der zweiten Zugriffsanforderung in der Einteilungswarteschlange durch den Speichercontroller, wenn der zweite Rang gerade nicht aufgefrischt wird.

5. Verfahren nach einem der Ansprüche 1 bis 4, ferner umfassend:
Auffrischen des zweiten Rangs durch den Speichercontroller, wenn eine Quantität von Zugriffsanforderungen zum Zugreifen auf den zweiten Rang in dem DRAM, die sich in den empfangenen Zugriffsanforderungen befinden, nicht kleiner als die zweite Schwelle ist und eine Quantität aufgeschobener Auffrischungen an dem zweiten Rang größer als eine vorgegebene dritte Schwelle ist, wobei die dritte Schwelle nicht kleiner als 1 ist und kleiner als ein vorgebebener Warnwert ist und der Warnwert verwendet wird, um eine Notwendigkeit anzugeben, sofort eine Auffrischoperation an dem zweiten Rang auszuführen.

6. Verfahren nach einem der Ansprüche 1 bis 5, ferner umfassend:
Überspringen des Ausführens einer Auffrischoperation an einem dritten Rang durch den Speichercontroller, wenn eine Quantität von Zugriffsanforderungen zum Zugreifen auf den dritten Rang in dem DRAM, die sich in den empfangenen Zugriffsanforderungen befinden, nicht kleiner als die zweite Schwelle ist und eine Quantität aufgeschobener Auffrischungen an dem dritten Rang nicht größer als die vorgegebene dritte Schwelle ist, wobei die dritte Schwelle nicht kleiner als 1 ist und kleiner als der vorgegebene Warnwert ist und der Warnwert verwendet wird, um einen Notwendigkeit anzugeben, sofort eine Auffrischoperation an dem dritten Rang auszuführen.

7. Speicherauffrischverfahren nach Anspruch 1, wobei das Auffrischen des ersten Rangs durch den Speichercontroller Folgendes umfasst:
Auffrischen des ersten Rangs durch den Speichercontroller in einem T-Intervall, wenn eine Quantität von Zielrängen der empfangenen Zugriffsanforderungen nicht kleiner als eine vorgegebene vierte Schwelle ist und ein Anteil von Leseanforderungen oder Schreibanforderungen in den Zugriffsanforderungen nicht größer als eine vorgegebene fünfte Schwelle ist, wobei T verwendet wird, um ein Standard-Durchschnittsauffrischintervall anzugeben.

8. Computersystem (100), das einen Speichercontroller (106) und einen dynamischen Direktzugriffsspeicher (108) bzw. DRAM, der mit dem Speichercontroller (106) verbunden ist, umfasst, wobei der Speichercontroller (106) dafür ausgelegt ist, das Verfahren nach einem der Ansprüche 1-7 auszuführen.

9. Speicherauffrischvorrichtung (400), wobei die Speicherauffrischvorrichtung (400) dafür ausgelegt ist, einen dynamischen Direktzugriffsspeicher (108) bzw. DRAM in einem Computersystem (100) aufzufrischen, und Folgendes umfasst:
ein Empfangsmodul (402), ausgelegt zum Empfangen von Zugriffsanforderungen zum Zugreifen auf den DRAM, wobei die Zugriffsanforderungen zum Zugreifen auf den DRAM Zugriffsanforderungen zum Zugreifen auf einen ersten Rang des DRAM umfassen;
ein statistisches Modul (404), ausgelegt zum Bestimmen, ob eine Quantität der empfangenen Zugriffsanforderungen zum Zugreifen auf den DRAM größer als eine erste Schwelle ist, und wenn die Quantität der empfangenen Zugriffsanforderungen zum Zugreifen auf den DRAM größer als die erste Schwelle ist, Bestimmen, ob eine Quantität der Zugriffsanforderungen zum Zugreifen auf den ersten Rang größer als eine zweite Schwelle ist; und
ein Auffrischmodul (408), ausgelegt zum Auffrischen des ersten Rangs, wenn eine Quantität von Zugriffsanforderungen zum Zugreifen auf den ersten Rang in dem DRAM, die in den empfangenen Zugriffsanforderungen enthalten sind, größer als 0 und kleiner als die zweite Schwelle ist, in einem Fall in einem Standard-Durchschnittsauffrischintervall und in einem anderen Fall auf der Basis der Quantität der Zugriffsanforderungen in einem T/N-Intervall, wobei T das Standard-Durchschnittsauffrischintervall ist und N eine ganze Zahl größer als 1 ist.

10. Speicherauffrischvorrichtung nach Anspruch 9, wobei
das Auffrischmodul (408) ausgelegt ist zum Auffrischen des ersten Rangs in dem T/N-Intervall, wenn eine Quantität von Zielrängen der empfangenen Zugriffsanforderungen kleiner als eine vorgegebene vierte Schwelle ist und ein Anteil von Leseanforderungen oder Schreibanforderungen in den Zugriffsanforderungen größer als eine vorgegebene fünfte Schwelle ist, wobei die Zielränge Ränge sind, auf die durch Verwendung der empfangenen Zugriffsanforderungen zum Zugreifen auf den DRAM zugegriffen werden soll.

11. Speicherauffrischvorrichtung nach Anspruch 9, wobei
das Empfangsmodul (402) ferner dafür ausgelegt ist, in einem Prozess des Auffrischens des ersten Rangs eine erste Zugriffsanforderung zum Zugreifen auf den ersten Rang zu empfangen; und
die Speicherauffrischvorrichtung (400) ferner Folgendes umfasst:
ein Puffermodul (410), ausgelegt zum Puffern der ersten Zugriffsanforderung in einer konfigurierten Pufferwarteschlange, wobei das Puffermodul mindestens die Pufferwarteschlange und eine Einteilungswarteschlange umfasst, wobei die Pufferwarteschlange verwendet wird, um eine Zugriffsanforderung für einen Rang zu puffern, an dem gerade eine Auffrischoperation ausgeführt wird, und die Einteilungswarteschlange verwendet wird, um eine Zugriffsanforderung zu puffern, die zu einem Rang gesendet werden soll, an dem gerade keine Auffrischoperation ausgeführt wird.

12. Speicherauffrischvorrichtung nach Anspruch 11, wobei
das Empfangsmodul (402) ferner ausgelegt ist zum Empfangen einer zweiten Zugriffsanforderung zum Zugreifen auf einen zweiten Rang in dem DRAM; und das Puffermodul (410) ferner ausgelegt ist zum Puffern der zweiten Zugriffsanforderung in der Einteilungswarteschlange, wenn der zweite Rang gerade nicht aufgefrischt wird.

13. Speicherauffrischvorrichtung nach einem der Ansprüche 9 bis 12, wobei
das Auffrischmodul (408) ferner ausgelegt ist zum Auffrischen des zweiten Rangs, wenn eine Quantität von Zugriffsanforderungen zum Zugreifen auf den zweiten Rang in dem DRAM, die sich in den empfangenen Zugriffsanforderungen befinden, nicht kleiner als die zweite Schwelle ist und eine Quantität aufgeschobener Auffrischungen an dem zweiten Rang größer als eine vorgegebene dritte Schwelle ist, wobei die dritte Schwelle nicht kleiner als 1 ist und kleiner als ein vorgebebener Warnwert ist und der Warnwert verwendet wird, um eine Notwendigkeit anzugeben, sofort eine Auffrischoperation an dem zweiten Rang auszuführen.

14. Speicherauffrischvorrichtung nach einem der Ansprüche 9 bis 13, wobei
das Auffrischmodul (408) ferner ausgelegt ist zum Überspringen des Ausführens einer Auffrischoperation an einem dritten Rang, wenn eine Quantität von Zugriffsanforderungen zum Zugreifen auf den dritten Rang in dem DRAM, die sich in den empfangenen Zugriffsanforderungen befinden, nicht kleiner als die zweite Schwelle ist und eine Quantität aufgeschobener Auffrischungen an dem dritten Rang nicht größer als die vorgegebene dritte Schwelle ist, wobei die dritte Schwelle nicht kleiner als 1 ist und kleiner als der vorgegebene Warnwert ist und der Warnwert verwendet wird, um eine Notwendigkeit anzugeben, sofort eine Auffrischoperation an dem dritten Rang auszuführen.

15. Speicherauffrischvorrichtung nach Anspruch 9, wobei
das Auffrischmodul (408) ausgelegt ist zum Auffrischen des ersten Rangs in einem T-Intervall, wobei eine Quantität von Zielrängen der empfangenen Zugriffsanforderungen nicht kleiner als eine vorgegebene vierte Schwelle ist und ein Anteil von Leseanforderungen oder Schreibanforderungen in den Zugriffsanforderungen nicht größer als eine vorgegebene fünfte Schwelle ist, wobei T verwendet wird, um ein Standard-Durchschnittsauffrischintervall anzugeben.

16. Computerlesbares Speicherungsmedium, das eine oder mehrere computerausführbare Anweisungen umfasst, wobei, wenn die eine oder mehreren computerausführbaren Anweisungen durch einen Computer ausgeführt werden, der Computer das Verfahren nach einem der Ansprüche 1-7 ausführt.

## Revendications

1. Procédé de rafraîchissement de mémoire, lequel procédé est appliqué à un système informatique comprenant un contrôleur de mémoire et une mémoire vive dynamique, notée DRAM, et lequel procédé comprend :
la réception (301), par le contrôleur de mémoire, de requêtes d'accès pour l'accès à la DRAM, les requêtes d'accès pour l'accès à la DRAM comportant des requêtes d'accès pour l'accès à un premier rang de la DRAM ;
la détermination (302), par le contrôleur de mémoire, si une quantité des requêtes d'accès reçues pour l'accès à la DRAM est supérieure ou non à un premier seuil ;
si la quantité de requêtes d'accès reçues pour l'accès à la DRAM est supérieure au premier seuil, la détermination (304), par le contrôleur de mémoire, si une quantité des requêtes d'accès pour l'accès au premier rang est supérieure ou non à un deuxième seuil ; et
le rafraîchissement (310), par le contrôleur de mémoire, du premier rang lorsqu'une quantité des requêtes d'accès pour l'accès au premier rang est supérieure à 0 et inférieure au deuxième seuil, dans un cas à un intervalle de rafraîchissement standard moyen et, dans un autre cas en fonction de la quantité des requêtes d'accès, à un intervalle T/N, T étant l'intervalle de rafraîchissement standard moyen et N étant un entier supérieur à 1.

2. Procédé de rafraîchissement de mémoire selon la revendication 1, dans lequel le rafraîchissement, par le contrôleur de mémoire, du premier rang comprend :
le rafraîchissement, par le contrôleur de mémoire, du premier rang à l'intervalle T/N lorsqu'une quantité de rangs cibles des requêtes d'accès reçues est inférieure à un quatrième seuil spécifié et une proportion de requêtes de lecture ou de requêtes d'écriture dans les requêtes d'accès est supérieure à un cinquième seuil spécifié, les rangs cibles étant des rangs devant être accédés par utilisation des requêtes d'accès reçues pour l'accès à la DRAM

3. Procédé selon la revendication 1 ou 2, comprenant en outre :
dans un processus de rafraîchissement du premier rang par le contrôleur de mémoire, la réception, par le contrôleur de mémoire, d'une première requête d'accès pour l'accès au premier rang ; et
le tamponnage, par le contrôleur de mémoire, de la première requête d'accès dans une file d'attente de tampon configurée, le contrôleur de mémoire comprenant au moins la file d'attente de tampon et une file d'attente d'ordonnancement, la file d'attente de tampon étant utilisée pour tamponner une requête d'accès pour un rang sur lequel une opération de rafraîchissement est en cours de réalisation, et la file d'attente d'ordonnancement étant utilisée pour tamponner une requête d'accès à envoyer à un rang sur lequel une opération de rafraîchissement n'est pas en cours de réalisation.

4. Procédé selon la revendication 3, comprenant en outre :
la réception, par le contrôleur de mémoire, d'une deuxième requête d'accès pour l'accès à un deuxième rang dans la DRAM ; et
le tamponnage, par le contrôleur de mémoire, de la deuxième requête d'accès dans la file d'attente d'ordonnancement lorsque le deuxième rang n'est pas en cours de rafraîchissement.

5. Procédé selon l'une quelconque des revendications 1 à 4, comprenant en outre :
le rafraîchissement, par le contrôleur de mémoire, du deuxième rang lorsqu'une quantité de requêtes d'accès pour l'accès au deuxième rang dans la DRAM qui figurent dans les requêtes d'accès reçues n'est pas inférieure au deuxième seuil et une quantité de rafraîchissements différés sur le deuxième rang est supérieure à un troisième seuil spécifié, le troisième seuil n'étant pas inférieur à 1 et étant inférieur à une valeur d'alerte spécifiée, et la valeur d'alerte étant utilisée pour indiquer une nécessité de réaliser immédiatement une opération de rafraîchissement sur le deuxième rang.

6. Procédé selon l'une quelconque des revendications 1 à 5, comprenant en outre :
le saut, par le contrôleur de mémoire, de la réalisation d'une opération de rafraîchissement sur un troisième rang lorsqu'une quantité de requêtes d'accès pour l'accès au troisième rang dans la DRAM qui figurent dans les requêtes d'accès reçues n'est pas inférieure au deuxième seuil et une quantité de rafraîchissement différés sur le troisième rang n'est pas supérieure au troisième seuil spécifié, le troisième seuil n'étant pas inférieur à 1 et étant inférieur à la valeur d'alerte spécifiée, et la valeur d'alerte étant utilisée pour indiquer une nécessité de réaliser immédiatement une opération de rafraîchissement sur le troisième rang.

7. Procédé de rafraîchissement de mémoire selon la revendication 1, dans lequel le rafraîchissement, par le contrôleur de mémoire, du premier rang comprend :
le rafraîchissement, par le contrôleur de mémoire, du premier rang à un intervalle T lorsqu'une quantité de rangs cibles des requêtes d'accès reçues n'est pas inférieure à un quatrième seuil spécifié et une proportion de requêtes de lecture ou de requêtes d'écriture dans les requêtes d'accès n'est pas supérieure à un cinquième seuil spécifié, T étant utilisé pour indiquer un intervalle de rafraîchissement standard moyen.

8. Système informatique (100), comprenant un contrôleur de mémoire (106) et une mémoire vive dynamique (108), notée DRAM, reliée au contrôleur de mémoire (106), le contrôleur de mémoire (106) étant configuré pour réaliser le procédé selon l'une quelconque des revendications 1 à 7.

9. Appareil de rafraîchissement de mémoire (400), lequel appareil de rafraîchissement de mémoire (400) est configuré pour rafraîchir une mémoire vive dynamique (108), notée DRAM, dans un système informatique (100), et comprend :
un module de réception (402), configuré pour recevoir des requêtes d'accès pour l'accès à la DRAM, les requêtes d'accès pour l'accès à la DRAM comportant des requêtes d'accès pour l'accès à un premier rang de la DRAM ;
un module statistique (404), configuré pour : déterminer si une quantité des requêtes d'accès reçues pour l'accès à la DRAM est supérieure ou non à un premier seuil et, si la quantité des requêtes d'accès reçues pour l'accès à la DRAM est supérieure au premier seuil, déterminer si une quantité des requêtes d'accès pour l'accès au premier rang est supérieure ou non à un deuxième seuil ; et
un module de rafraîchissement (408), configuré pour rafraîchir le premier rang lorsqu'une quantité de requêtes d'accès pour l'accès au premier rang dans la DRAM qui figurent dans les requêtes d'accès reçues est supérieure à 0 et inférieure au deuxième seuil, dans un cas à un intervalle de rafraîchissement standard moyen et, dans un autre cas en fonction de la quantité des requêtes d'accès, à un intervalle T/N, T étant l'intervalle de rafraîchissement standard moyen et N étant un entier supérieur à 1.

10. Appareil de rafraîchissement de mémoire selon la revendication 9, dans lequel
le module de rafraîchissement (408) est configuré pour rafraîchir le premier rang à l'intervalle T/N lorsqu'une quantité de rangs cibles des requêtes d'accès reçues est inférieure à un quatrième seuil spécifié et une proportion de requêtes de lecture ou de requêtes d'écriture dans les requêtes d'accès est supérieure à un cinquième seuil spécifié, les rangs cibles étant des rangs devant être accédés par utilisation des requêtes d'accès reçues pour l'accès à la DRAM.

11. Appareil de rafraîchissement de mémoire selon la revendication 9, dans lequel
le module de réception (402) est configuré en outre pour : dans un processus de rafraîchissement du premier rang, recevoir une première requête d'accès pour l'accès au premier rang ; et
lequel appareil de rafraîchissement de mémoire (400) comprend en outre :
un module tampon (410), configuré pour tamponner la première requête d'accès dans une file d'attente de tampon configurée, le module tampon comprenant au moins la file d'attente de tampon et une file d'attente d'ordonnancement, la file d'attente de tampon étant utilisée pour tamponner une requête d'accès pour un rang sur lequel une opération de rafraîchissement est en cours de réalisation, et la file d'attente d'ordonnancement étant utilisée pour tamponner une requête d'accès à envoyer à un rang sur lequel une opération de rafraîchissement n'est pas en cours de réalisation.

12. Appareil de rafraîchissement de mémoire selon la revendication 11, dans lequel
le module de réception (402) est configuré en outre pour recevoir une deuxième requête d'accès pour l'accès à un deuxième rang dans la DRAM ; et
le module tampon (410) est configuré en outre pour tamponner la deuxième requête d'accès dans la file d'attente d'ordonnancement lorsque le deuxième rang n'est pas en cours de rafraîchissement.

13. Appareil de rafraîchissement de mémoire selon l'une quelconque des revendications 9 à 12, dans lequel
le module de rafraîchissement (408) est configuré en outre pour rafraîchir le deuxième rang lorsqu'une quantité de requêtes d'accès pour l'accès au deuxième rang dans la DRAM qui figurent dans les requêtes d'accès reçues n'est pas inférieure au deuxième seuil et une quantité de rafraîchissements différés sur le deuxième rang est supérieure à un troisième seuil spécifié, le troisième seuil n'étant pas inférieur à 1 et étant inférieur à une valeur d'alerte spécifiée, et la valeur d'alerte étant utilisée pour indiquer une nécessité de réaliser immédiatement une opération de rafraîchissement sur le deuxième rang.

14. Appareil de rafraîchissement de mémoire selon l'une quelconque des revendications 9 à 13, dans lequel
le module de rafraîchissement (408) est configuré en outre pour sauter le rafraîchissement d'un troisième rang lorsqu'une quantité de requêtes d'accès pour l'accès au troisième rang dans la DRAM qui figurent dans les requêtes d'accès reçues n'est pas inférieure au deuxième seuil et une quantité de rafraîchissement différés sur le troisième rang n'est pas supérieure au troisième seuil spécifié, le troisième seuil n'étant pas inférieur à 1 et étant inférieur à la valeur d'alerte spécifiée, et la valeur d'alerte étant utilisée pour indiquer une nécessité de réaliser immédiatement une opération de rafraîchissement sur le troisième rang.

15. Appareil de rafraîchissement de mémoire selon la revendication 9, dans lequel
le module de rafraîchissement (408) est configuré pour rafraîchir le premier rang à un intervalle T lorsqu'une quantité de rangs cibles des requêtes d'accès reçues n'est pas inférieure à un quatrième seuil spécifié et une proportion de requêtes de lecture ou de requêtes d'écriture dans les requêtes d'accès n'est pas supérieur à un cinquième seuil spécifié, T étant utilisé pour indiquer un intervalle de rafraîchissement standard moyen.

16. Support d'enregistrement lisible par ordinateur, comprenant une ou plusieurs instructions exécutables par ordinateur ; lorsque les une ou plusieurs instructions exécutables par ordinateur sont exécutées par un ordinateur, l'ordinateur réalisant le procédé selon l'une quelconque des revendications 1 à 7.
